(19)

Europäisches
Patentamt
European
Patent Office
Office européen
des brevets

(11) **EP 2 073 607 A1**

(12) **EUROPEAN PATENT APPLICATION**

(43) Date of publication:
**24.06.2009 Bulletin 2009/26**

(51) Int Cl.:
***H05B 33/08*** *(2006.01)*

(21) Application number: **07024653.3**

(22) Date of filing: **19.12.2007**

(84) Designated Contracting States:
**AT BE BG CH CY CZ DE DK EE ES FI FR GB GR
HU IE IS IT LI LT LU LV MC MT NL PL PT RO SE
SI SK TR**
Designated Extension States:
**AL BA HR MK RS**

(71) Applicant: **Data Display GmbH
82110 Germering (DE)**

(72) Inventor: **Staller, Bernhard
82110 Germering (DE)**

(74) Representative: **Zinkler, Franz et al
Schoppe, Zimmermann, Stöckeler & Zinkler
Patentanwälte
Postfach 246
82043 Pullach bei München (DE)**

(54) **LED-controller for optimizing LED lifetime**

(57)     In method and a controller (130) for controlling a light emitting diode (LED) (138) in LED backlighting systems for liquid crystal display (LCD) modules, a junction temperature of the LED (138) is determined and an average current supplied to the LED (138) is modified based on the determined junction temperature.

## FIG 6A

**Description**

Background

The present invention relates to the field of light emitting diodes, especially to a method and a controller for controlling a light emitting diode (LED). More specifically, the present invention relates to the lifetime stabilization of LED backlights via direct temperature control.

LED backlighting systems for liquid crystal display (LCD) modules often may occupy a cavity or cavities within the LCD module which were originally designed for cold cathode fluorescent lamps (CCFLs) and associated lamp holders configured as devices that illuminate the edges of an acrylic light guide which in turn backlights the LCD.

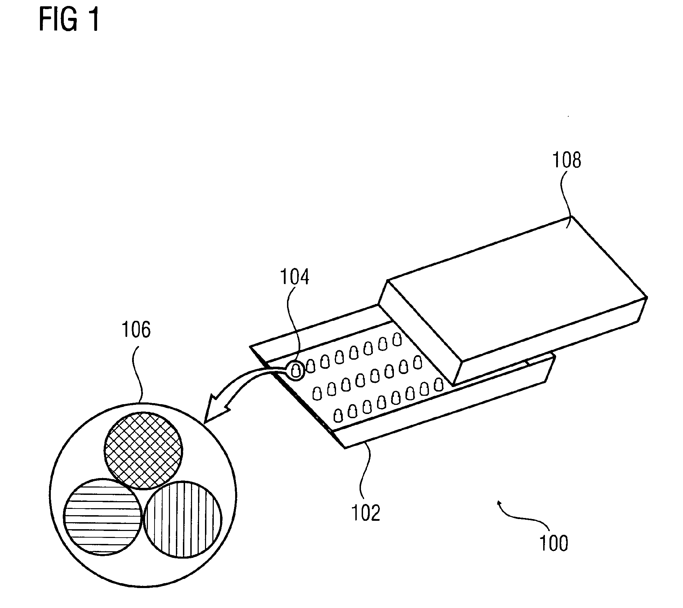

In other cases LED backlit LCDs are manufactured using LEDs arranged in a matrix configuration placed directly behind the light guide. Fig. 1 shows an example for such a LCD 100 having a housing 102 holding a plurality of light sources 104. The respective light sources 104 are formed by three LEDs 104a, 104b, 104c of different colors (e.g., red, green, blue) as is shown in the enlarged portion 106. The housing 102 is covered with a LCD layer 108 (all shown only schematically).

LEDs are more desirable than CCFLs in many LCD applications due to their advantages over CCFL based edge lighting systems, including:

- greater reliability under extreme shock and vibration,
- reduced hazardous material content (mercury-free and lead-free),
- long useful lifetime before field replacement is necessary,
- ability to startup and operate at extremely low temperatures,
- low voltage power supply requirements, and
- reduced electromagnetic emissions.

LED "rails" may be designed such that they occupy no more space (volume) than original equipment CCFL lamp holders, since the CCFL lamp holder assemblies are removed and replaced with LED rails as part of an upgrade or value-added enhancement process.

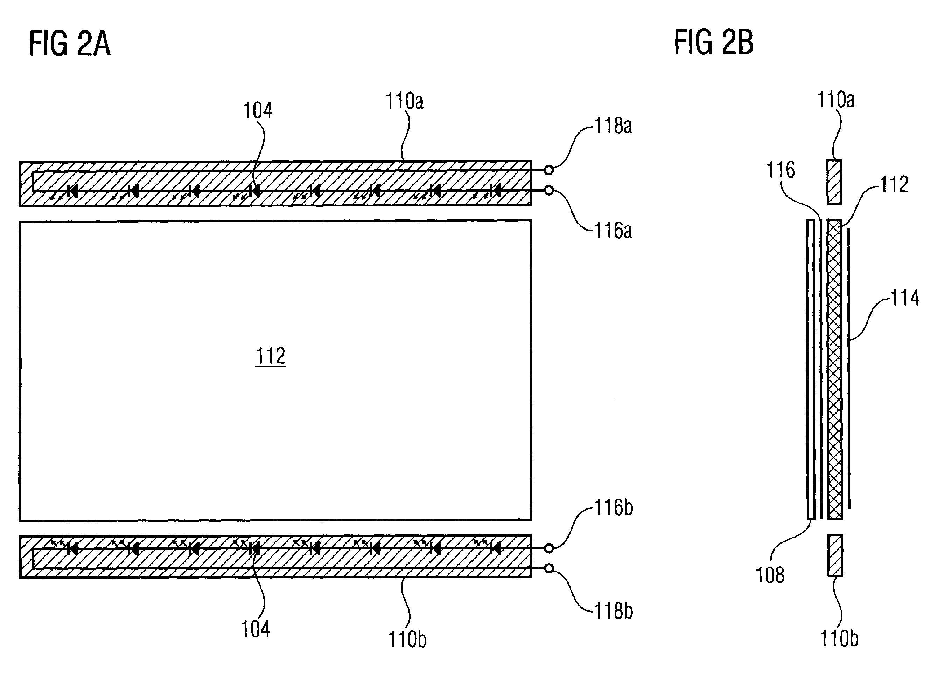

Fig. 2A and 2B illustrate an example transmissive liquid crystal display (LCD) module, in which Fig. 2A is a top view and Fig. 2B is a cross sectional view. The LCD module 100 utilizes dual LED rails 110a, 110b to illuminate a light guide 112. The light guide 112 acts to distribute light emitted by the LEDs 104 evenly across the back surface of the LCD 108. Reflector 114 serves to redirect light which may reflect off of the light guide back 112 back to the LCD 108. Reference sign 116 represents any polarizing films which may be provided in the module. The LEDs 104 in the respective rails 114a, 114b are arranged in series between an input 116a, 116b and an output 118a, 118b. The inputs receives respective drive signals (drive currents) for driving the LEDs 104.

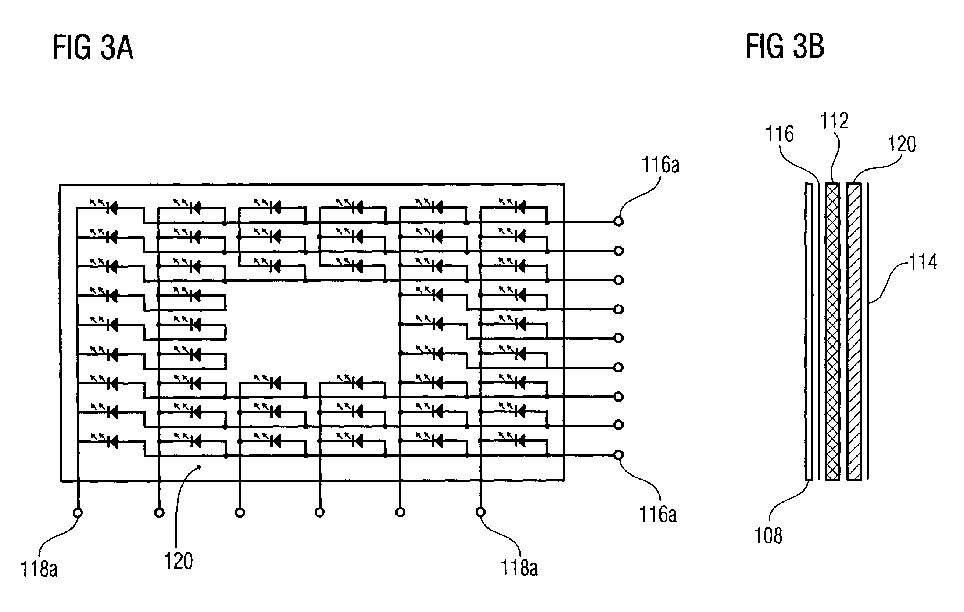

Fig. 3A illustrates a transmissive LCD module which utilizes LEDs 104 in a matrix configuration 120 to illuminate the LCD 108. In this case the light guide 112 also functions as a diffuser and to a lesser extent is used to distribute the light evenly across the back the LCD 108. Fig. 3B shows a typical layer stack of an LED backlit LCD module in a side view. Reflector 114 serves to redirect light which may reflect off of the light guide 112 back out through the LCD. The LED matrix is shown at 120 and the acrylic light guide is shown at 112. Reference sign 116 represents any polarizing films which the module may contain. Reference sign 108 represents the liquid crystal display itself. The inputs 116a to 116n and the outputs 118a to 118n for the LEDs in the matrix 120 are also shown.

The backlighting system of Fig. 3 provides the light that is transmitted through the LCD for the benefit of the user. The stack of an edgelit LCD module is similar except that the LED rails 110a, 110b (see Fig. 2) are mounted on the same plane as the light guide 112, rather than being mounted behind it as in the matrix backlight configuration (Fig. 3). In the figures white LEDs are shown, however, red, green and blue LEDs may also be used.

The rail or matrix configuration comprises a printed circuit board assembly, fabricated from copper clad FR-4 or other base materials, upon which the LEDs 104 (see Figs. 2 and 3), usually white, but occasionally red, green and blue to form white light are mounted and connected in either a series, parallel or series-parallel configuration. Often a ceramic, metal or composite substrate (or core) is used in the construction of the printed circuit board to aid in the removal of heat from the LEDs.

Most LED failure mechanisms are temperature dependent. Elevated junction temperature $T_j$ causes reduction of light output and accelerated device degradation. The maximum junction temperature $T_{jmax}$ for a LED is e.g. specified in the manufacturer's product data sheet.

To avoid such problems as reduction of light output or accelerated device degradation, a conventional constant current source used for supplying the LEDs in the above described configurations with power will have its output derated such that the current source would not cause the $T_j$ to exceed $T_{jmax}$ at higher operating temperatures. This problem is exacerbated by the fact that the typical edge lighting or backlighting cavity volume is restrictive and thermally conductive material is rarely used in the construction of the LCD module surrounding the cavity, so removal of heat by conduction may not be possible.

Summary of the Invention

It is the object of the present invention to provide an approach for increasing the lifetime of a light emitting diode (LED) in a display system while maintaining the current provided to the LED substantially constant to allow operating the LED with predefined thermal, electrical and optical characteristics.

This object is achieved by a method according to claim 1, and by a controller according to claim 7.

The present invention provides a method for controlling a light emitting diode (LED), comprising:

determining a junction temperature of the LED; and

based on the determined junction temperature, modifying an average current supplied to the LED.

The present invention provides a controller for a LED, comprising:

an input for receiving an input signal indicative of a junction temperature of the LED;

an enable signal generator for generating an enable signal having a duty cycle;

a processor coupled to the input and to the enable signal generator, the processor configured to modify the duty cycle of the enable signal on the basis of the input signal; and

an output coupled to the enable signal generator for outputting the enable signal.

Further, the present invention provides a LED and a display device comprising the inventive controller.

Brief Description of the Drawings

In the following, embodiments of the invention will be described with reference to the accompanying drawings, in which

Fig. 1      shows an example of a LED backlit LCD;

Fig. 2      illustrates an example transmissive liquid crystal display (LCD) module, in which Fig. 2A is a top view and Fig. 2B is a cross sectional view;

Fig. 3      illustrates a transmissive LCD module which utilizes LEDs in a matrix configuration, in which Fig. 3A is a top view and Fig. 3B shows a typical layer stack of an LED backlit LCD module in a side view;

Fig. 4A     shows a thermal resistance model for a LED chip;

Fig. 4B     shows a graph indicating how changes in the junction temperature Tj affect the useful life time of a LED;

Fig. 5      shows charts indicating the relative light output versus junction temperature over time at a low Tj (Fig. 5A) and at a high Tj (Fig. 5B);

Fig. 6      shows block diagrams of LED systems comprising a controller in accordance with embodiments of the invention, wherein Fig. 6A shows a block diagram with an externally powered sensor and Fig. 6B shows a block diagram with a sensor powered by the LED; and

Fig. 7      shows a block diagram of a controller in accordance with a further embodiment of the invention.

Description of the Embodiments

As mentioned above, an elevated junction temperature Tj in a LED causes reduction of light output and accelerated device degradation. Thus a maximum junction temperature Tjmax for a LED as it is e.g. specified in the manufacturer's product data sheet should not be exceeded. The junction temperature (Tj) is primarily affected by three parameters:

- the ambient temperature (Ta) of the LED's immediate surroundings, inside the cavity,
- the thermal path between the LED junction and its ambient conditions,
- the power dissipated by the LED (Pd, in Watts), Pd is the product of the forward voltage ($Vf_{LED}$) and the forward current ($If_{LED}$) of the LED.

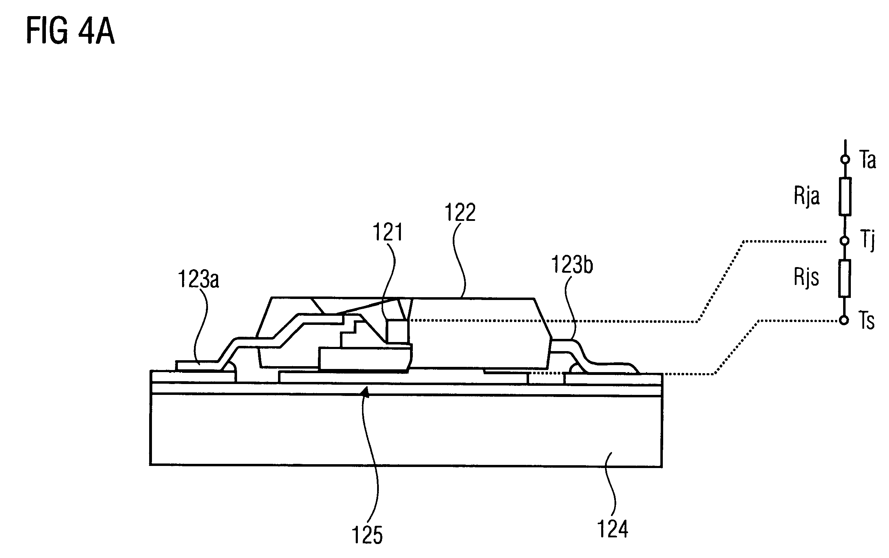

Fig. 4A shows a thermal resistance model for a LED 104. The LED 104 comprises a LED chip 121 encapsulated in a resin housing 121 and having respective terminals 123a, 123b. The LED is mounted to a substrate 124. Fig. 4A indicates the thermal resistances Rja and Rjs. The thermal resistance Rjs is the thermal resistance between the LED junction and the cathode of the LED or the substrate (the portion 125 where the housing is in contact with the substrate). Ts indicates the temperature measured at the cathode terminal or at the substrate by a temperature sensor. The thermal resistance Rja is the thermal resistance between the LED junction and the ambient of the LED. Ta indicates the temperature measured in proximity to the housing by a temperature sensor.

Tj may be determined in one of two ways using information published in the LED datasheet. In equation 1, Tj is the sum of Ta and the product of the thermal resistance from the junction to ambient (Rja, units °C/W) and Pd. Rja is listed in the datasheet for the LED. The product of Rja and Pd represents the temperature rise of the LED junction above ambient.

$$Tj = Ta + (Rja \times Pd) \qquad\qquad equation\ 1$$

The thermal resistance between two points is defined as the ratio of the difference in temperature to the power dissipated. The thermal contact 125 (see Fig. 4A) at the bottom of the LED package, or in some cases the cathode terminal of a typical white LED, is the primary thermal path for the dissipation of heat from the LED junction to the surrounding ambient or substrate. The datasheet lists the thermal resistance from the LED junction to the thermal contact, or cathode terminal solder point to ambient (Rjs) for the device with a specified printed circuit board construction. This device thermal resistance is added to the product of Rjs, units °C/W, and Pd to obtain Tj using the second relationship:

$$Tj = Ts + Rjs \times Pd \qquad\qquad equation\ 2$$

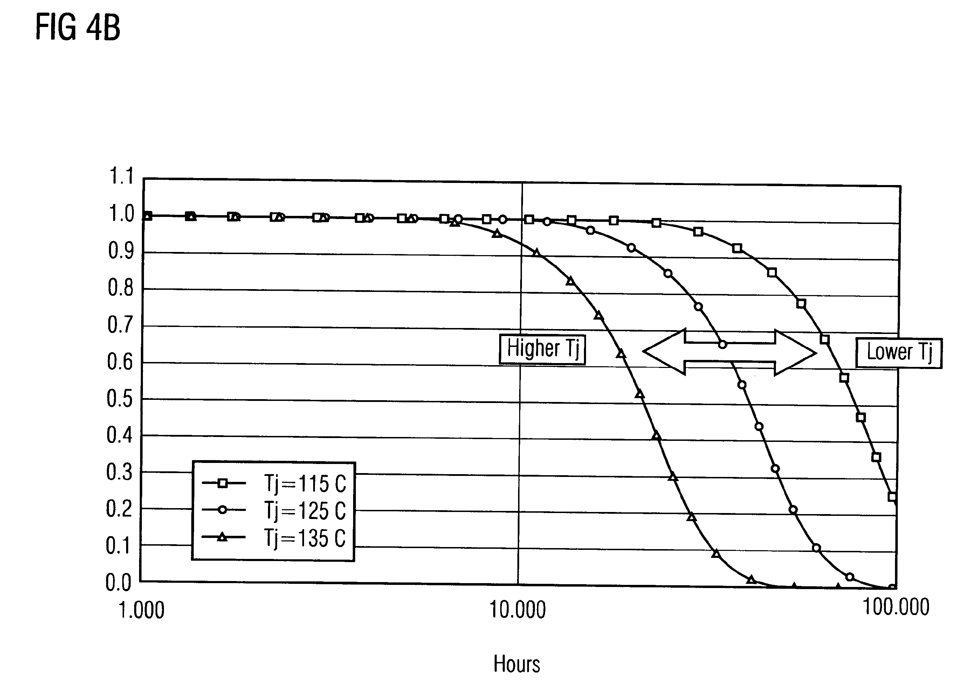

As the ambient temperature increases, at a given $If_{LED}$, $Vf_{LED}$ decreases in a predictable way, and, in turn, Pd decreases, so the LED contributes less heat. Conversely as the ambient temperature decreases $VO_{LED}$ increases in a predictable way, and, in turn, Pd increases, so the LED contributes more heat. Fig. 4B shows how changes in the junction temperature Tj affect the useful life time of a LED. This can be taken into account in the algorithm since the change in Pd will be known. The algorithm will include hysteresis so that modifications to the duty cycle (or average current) do not happen so quickly that the eye perceives a flashing or other noticeable change in luminance.

The sensor feedback signal, value or communication levels may require voltage level shifting at the logic or microcontroller side, since in certain configurations described above the ground pin of the sensor may not be connected to signal ground, so the sensor output may need to be level shifted in order to meet the input/output requirements of the logic or microcontroller.

In accordance with embodiments of the invention by using LED temperature feedback and average current control the LED lifetime can be accurately predicted and in fact controlled. The LED junction temperature is maintained and prevented from exceeding the LED manufacturer's maximum safe operating dice temperature. Further, the junction temperature is maintained as close as is possible to the level that the LED manufacturer specifies for a useful lifetime. Average current may be increased at low temperature or reduced at higher operating temperatures versus the level used at room temperature.

Maintaining a consistent junction temperature is critical to understanding when the need for field replacement will arrive (such as in a return on investment analysis), and is important in calculating mean time between/before failure (s) (MTBF). Without temperature feedback current control these times would not otherwise be known.

Lifetime for solid state LEDs is typically defined in terms of lumen maintenance (the percentage of initial light output remaining after a specified period of operating time). Many manufacturers of high-power white LEDs estimate a lifetime of around 30,000 hours to the 70% lumen maintenance level, assuming operation at 350 milliamps (mA) constant current and maintaining the Tjmax no higher than 90°C. Some LEDs available today are rated for 50,000 hours at 1000mA with a Tjmax of up to 120°C. Clearly in an enhanced LCD module with typical operating temperatures in excess of 70°C the junction temperature for the LED could approach or easily exceed this mark.

The primary cause of LED lumen depreciation (the decrease in lumen output that occurs as a lamp is operated) is heat generated at the LED junction. LEDs do not emit heat as infrared radiation, so the heat must be removed from the device by conduction or convection. Without adequate heat removal by sinking or by ventilation, the device temperature will rise, resulting in lower light output. Continuous operation at high temperature will cause a permanent reduction in light output.

LEDs will decrease in relative flux output as junction temperature (Tj) rises. Most LED data sheets list typical luminous flux at Tj = 25°C, while most LED applications use higher junction temperatures. When using Tj > 25°C, the luminous flux must be derated from the value listed on the LED's data sheet.

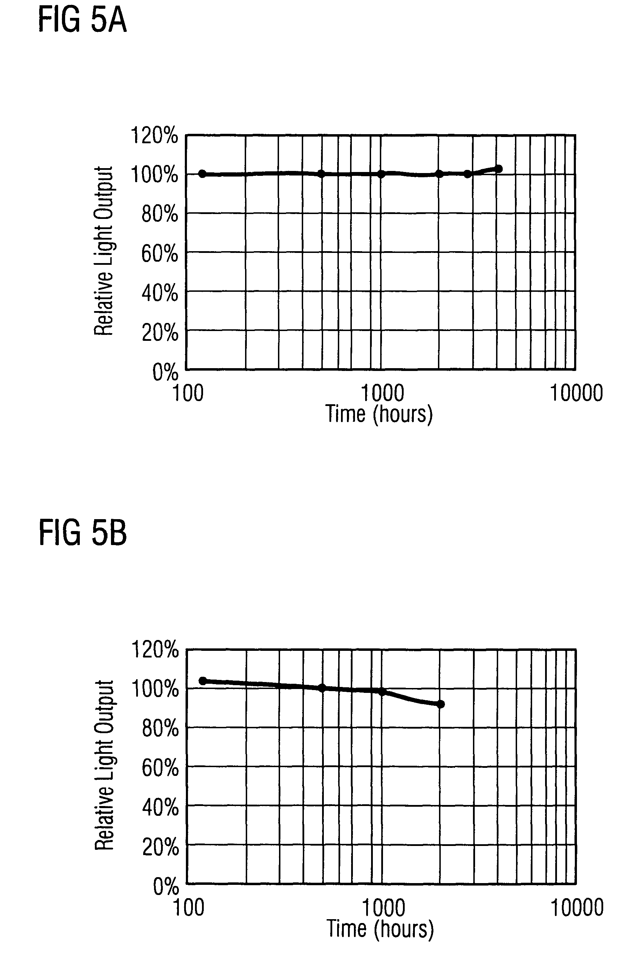

Fig. 5 shows charts indicating the relative light output versus junction temperature over time, wherein Fig. 5A shows the relative light output over time at a low Tj, and Fig. 5B shows the relative light output over time at a high Tj.

In a LCD environment as described above, due to the restrictive volume of the cavity and cable exit channel it is often impractical to add the additional wires and circuitry necessary to monitor the ambient operating temperature and/or the solder temperature for the LED. Many implementations of LED rail designs use multiple strings of isolated series LEDs, each string requiring two connector contacts, potentially using all available wiring channel area. In order to obtain more wiring channel or input connector area the rail would need to be extended beyond the perimeter of the LCD module. This option would be met with little market acceptance for many reasons including the preclusion of the great many LCD modules that do not have field replaceable CCFL lamp holders.

LCD modules with non-field replaceable lamp holders need to be disassembled in a clean environment in order to replace the lamp holder(s) with LED rail(s) without contaminating the LCD, light guide and internal film layers with dust, dirt and oil.

DC power and ground required by a temperature sensor must also be wired in separately. Such sensors typically require a low-level DC voltage and DC return (ground) in addition to the sensor output. Single chip temperature sensors are available with one-wire interfaces (bringing the total wires required to support the temperature feedback function to three). One-wire outputs can be PWM type, DC voltage proportional to temperature type or types supporting sophisticated serial device communication such as Sensor-Bus™.

It may not be possible to directly monitor the dice, or junction temperature of the LED since it is usually a silicone resin encapsulated blue LED chip with yellow phosphor on a ceramic substrate or similar construction, or it may contain a red, a green and a blue LED chip. In some configurations discrete red, green and blue LEDs are arranged in a matrix. There is very little to no airflow within the cavity, so most of the heat that is generated by devices within the cavity tends to stay there. As a result, as the ambient operating temperature of the LCD module increases the Tj of the LED increases in a predictable way.

Another problem is that LED characteristics are specified at a particular $If_{LED}$, and it may not be possible for a current regulator design to meet that target without overheating the LED dice. If the constant current source is indeed constant over temperature, and the heat sinking, spreading or dissipating characteristics of the rail or matrix implementation, in consideration of the maximum operating temperature requirements are for the LCD module, are such that it is necessary to reduce $If_{LED}$ to a level not used in characterization of the LED, few of the published optical and electrical specifications would pertain to the application, and it would be impossible to accurately determine critical features of the LCD module being enhanced. At lower temperatures $If_{LED}$ would have been unnecessarily reduced or derated to a level that results in a safe dice operating temperature at high ambient temperatures, critical to ensuring long useful life for the LED.

With a constant current source that is truly constant over the operating temperature range the tradeoff is that operation at room temperature and below is compromised, in terms of what luminance levels would be possible. Unfortunately room temperature is the environment we find most LCD modules in facility, medical and industrial environments being operated at.

It should again be noted that room temperature is the condition at which all of the optical and most of the electrical specifications for the LCD module are characterized. Often graphs are supplied to aid in understanding what the effect of changes in temperature and other variables will have on the characteristics. It should also be noted that important characteristics are specified at a single recommended $If_{LED}$. LED power supplies that vary $If_{LED}$ in order to dim the LED do not control or maintain any characteristic of the LCD, including lifetime.

In accordance with the present invention a closed-loop constant current control with temperature feedback modification of pulse width modulated current will modify the average current supplied to the LED as ambient temperature changes, while keeping critical optical characteristics constant. Knowing that it is important to know Tj in order to reduce the duty cycle of the PWM enable control (resulting in a reduction of the average current through the LED(s)) the junction temperature will be calculated using the measured, real-time value of the ambient temperature of the cavity in the immediate area of the LED, or, the temperature at some other point in the enclosure could be used, and knowing the thermal characteristics of the enclosure design the LED junction temperature could be calculated from the measured or modeled value. This will provide the unknown value for equation 1, Ta. Alternatively or coincidently, the real-time value of the solder temperature of the LED(s) could be measured to provide equation 2, Ts. Ideally both values would be made available to the control logic or microcontroller. Alternatively the operating temperature for the LCD module could be measured at any point within the enclosure and based on modeled or measured characteristics of the enclosure a delta temperature may be obtained which would represent the known difference between the operating temperature of the LCD module itself and the operating ambient within the LED rail cavity or LED solder temperature and the LED junction temperature determined based on that information.

Using these methods, LCD modules that are incredibly bright at room temperature and lower can be produced, since the average current provided to the LED would be much higher at lower temperatures than at higher temperatures, although the forward current through each LED remains constant or nearly constant throughout the specified operating temperature range for the LCD module. If$_{LED}$ remains constant in order to reliably use manufacturer's published thermal, electrical and optical characteristics. It is instead the average current that is modified.

In all known LED rail implementations, at least one wire, sometimes two or more carries If$_{LED}$ to the rail and a second (or more) is the return(s). In some cases the return is not at ground potential, but instead provides current feedback to a sense resistor which regulates the current supplied, and is located close to the constant current driver. In other cases the return is at the input voltage potential.

Embodiments of the invention provide a wiring minimized solution. A temperature sensor may be located within the rail cavity (rail located sensor concept) or it may be located within the enclosure used to house the LCD module (enclosure located sensor concept). For the rail located sensor concept, the additional wire(s) needed is at best a one-wire temperature sensor communication channel as described above which would provide a temperature value or values, pulse-width modulated or otherwise, or a voltage, which can be measured by an analog-to-digital converter to determine the corresponding temperature. The value provided from the sensor would equal the instantaneous solder temperature of the LED and/or the ambient temperature inside the cavity near the LED being measured. Measuring both temperatures would require the one-wire SensorBus™ or similar multi-peripheral communication channel, or other means of encoding the output of multiple sensors onto one wire. Alternatively, the sensor output could be modulated on any wire that connects the rail to the power supply, and demodulated before being presented to the control logic. Sensors with two-wire communication could also be used, such as those sensors having an I²C interface.

For the enclosure located sensor implementation, the temperature sensor may be located in what is known by measurement or by modeling to be a warm point within the enclosure, or it may be even be located on the bezel or other location that is not the warmest point. The temperature at that point will be known as the operating ambient temperature for the LCD module. The enclosure could be modeled or constructed and measurements made to determine the temperature delta between that point in the enclosure and the operating ambient within the LCD module in the area of the LEDs (in the rail cavity, for example). Normally what is known to be the area of the upper rail cavity would be used, since it would be hotter than the lower rail cavity. This temperature delta would be used in calculations to arrive Ta, Ts or both and in turn to arrive at Tj.

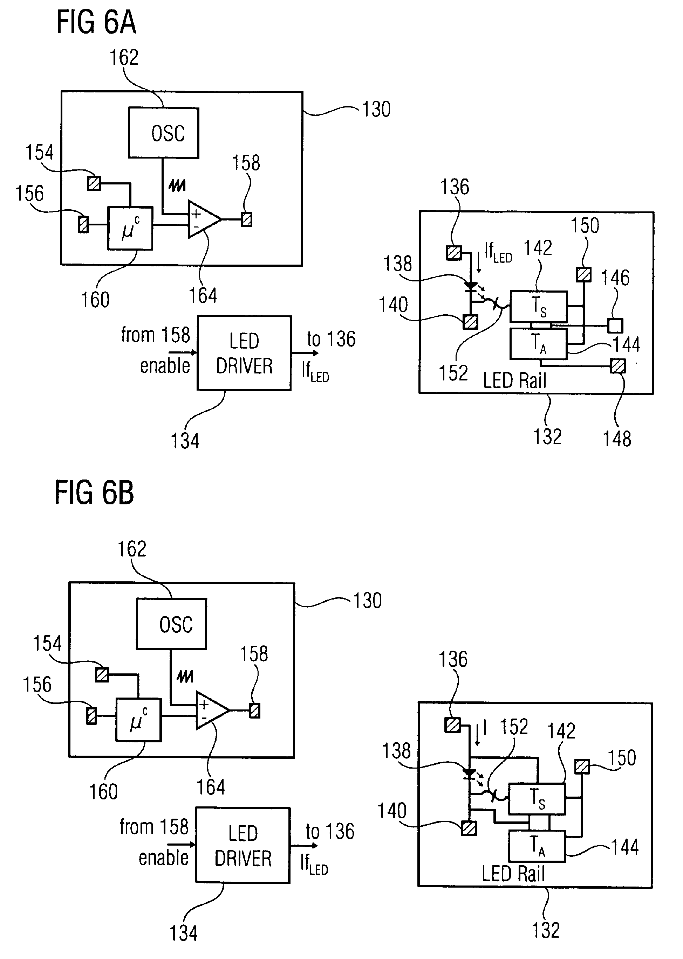

Fig. 6 shows two embodiments of the invention, wherein Fig. 6A shows a block diagram with an externally powered sensor and Fig. 6B shows a block diagram with a sensor powered by the LED.

Fig. 6A shows a system comprising a LED controller 130, a LED 132 and a conventional constant current regulator 134 for powering the LED 132. In the embodiment of Fig. 6A the LED 132 comprises an input 136 receiving a drive signal (e.g. current If$_{LED}$) from the regulator 134 which is fed to a LED chip 138. The LED chip 138 comprises a LED element having its anode coupled to the input 136 and having its cathode coupled to an output 140 which may be coupled to a reference potential (e.g. ground). In addition a first temperature sensor 142 and a second temperature sensor 144 are connected between a sensor power supply input 146 and an output 148 which may be coupled to a reference potential (e.g. ground). Both sensors 142, 144 have sensor outputs for providing output signals indicative of a sensed temperature to a temperature feedback output 150. The first sensor 142 is a cathode temperature sensor which is coupled to the LED element's cathode (see reference sign 152) and which detects the temperature at the cathode. The second sensor 144 is an ambient temperature sensor for measuring the LED element's ambient temperature as mentioned above. As mentioned above, this arrangement requires three additional wires, two for providing the operating power to the sensors and one for returning the temperature signal.

The controller 130 in this embodiment is a PWM duty cycle controller. The controller 130 comprises a temperature feedback input 154 coupled to the temperature feedback output 150 of the LED 132 for receiving the signal indicative of the temperature at the LED. Further, a control input 156 is provided for receiving a control signal indicative of a desired intensity of the light to be emitted by the diode. The controller 130 comprises an output 158 for outputting an enable signal having a duty cycle adjusted by the controller 130 to the regulator 134. A control circuit 160 in the controller 130 is coupled to the input 154 and the control input 156 and, on the basis of the received signals, provides an output signal. The control circuit generates a signal indicative of a current junction temperature of the LED in a manner as described above. In addition, an oscillator 162 outputting a saw tooth waveform is arranged in the controller 130 together with a comparator 164 receiving at its non-inverted input the output signal from the oscillator 162 and at its inverted input the signal from the control circuit 160. At its output, the comparator 164 provides the enable signal having the duty cycle set dependent from the temperature at the LED junction.

The embodiment of Fig. 6B corresponds substantially to the one described in Fig. 6A except that the sensors 142 and 144 in the LED 132 are not externally powered but are powered by the LED. Other than in the embodiment of Fig. 6A, in the embodiment of Fig. 6B only one additional wire for signaling the temperature to the controller 130 is required. The sensors 142, 144 are connected between the LED input 136 and the output 138.

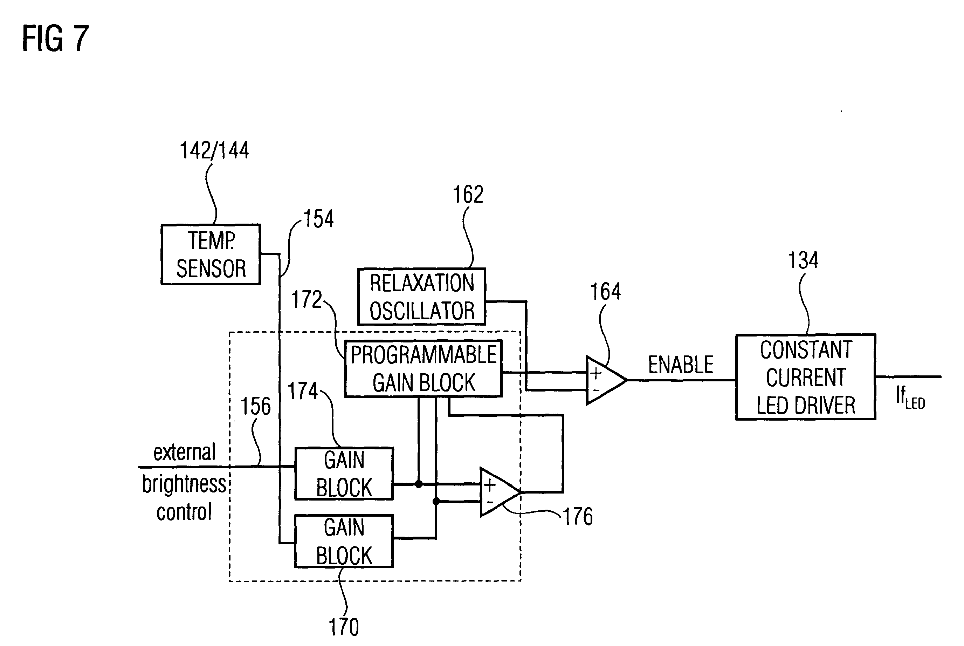

The functionality of the inventive controller and the underlying control method will be described below in further detail with reference to Fig. 7. Fig. 7 shows a block diagram of a controller in accordance with a further embodiment of the invention. Elements already described above with respect to Fig. 6 have associated therewith the same reference sign.

The temperature sensor 142 and/or 144, which may or may not be located in close proximity to the LED in a backlighting system, continuously measures the ambient temperature. Commercially available temperature sensing integrated circuits commonly provide either a DC voltage, a pulse-width modulated (PWM) or a serial data word to a first gain block 170, which may also provide level conversion or analog to digital conversion of the data. A lower-cost thermistor type device may also be used to provide measured temperature information. Data representing the temperature are provided to programmable gain block 172.

As is typical in an LCD based visual system, some means of user control of the backlight intensity is provided. This user control may be a simple potentiometer or a more elaborate on-screen display based user interface in which a microprocessor or microcontroller is used. The external brightness control data may be supplied to the circuit as a DC voltage or a brightness value which is pulse-width modulated. The external brightness control may also be a serial data word. A second gain block 174 may be required to decode the PWM or serial data word or to perform level translation and/or amplification of the external control signal.

Once properly conditioned the external brightness control data is compared to the measured and conditioned temperature control data. A first comparator 176 may have hysteresis such that it does not oscillate due to slowly changing temperature control value or external brightness control values.

In a low-cost implementation the programmable gain block 172 may act as a simple data demultiplexer/selector. Should the conditioned external brightness control data exceed an allowed value (as indicated by the measured temperature control value at any given time) programmable gain block 172 may be forced to pass the temperature control value to the comparator 164 for the purpose of modifying the duty cycle of the enable signal to the constant current LED driver 134. While functioning as a selector only the useable range of the external brightness control will be truncated at the point where the conditioned external brightness control exceeds the value of the conditioned temperature control data. As a result the user may not perceive a change in backlight brightness at the upper end of the control range.

In a more elaborate implementation programmable gain block 172 may also serve as a programmable gain amplifier, effectively scaling the external brightness control value such that the user would perceive a change in backlight brightness over the entire useable range of the external brightness control, from 0 to 5VDC for example without truncation of the useable range.

The relaxation oscillator 162 provides the saw tooth waveform of nearly constant frequency. The frequency of oscillation is selected such that the user does not perceive flickering of the backlighting system, and is usually fixed at just above 100Hz. The comparator 164 transitions its output at the point where the instantaneous value of the saw tooth waveform exceeds the DC voltage provided by programmable gain block 172, thus fixing the duty cycle of the enable signal to the constant current LED driver 134.

Constant current LED driver block 134 may be implemented as a buck, a boost or a buck-boost DC/DC converter circuit with closed-loop current regulation. The voltage generated must exceed the combined forward voltages of all LEDs in a series string. The current supplied will be such that the forward current equals the LED manufacturer's recommended level, or at some constant level at which the backlighting system has been characterized. A voltage is developed across a feedback resistor and presented to constant current LED driver 134, thus completing the current regulation loop.

It is important to note that the entire circuit or some portions of it (with the exclusion of the constant current LED driver) may be implemented in a microcontroller or programmable logic device (PLD). A mixed-signal PLD or application specific integrated circuit (ASIC) could also be used and may include the constant current LED driver block as well as temperature sensors 142 and/or 144.

**Claims**

1.  A method for controlling a light emitting diode (LED), comprising:

   determining a junction temperature of the LED (104; 121; 138); and

based on the determined junction temperature, modifying an average current supplied to the LED (104; 121; 138).

2. The method of claim 1, wherein modifying the average current supplied to the LED (104; 121; 138) comprises:

   modifying a duty cycle of an enable signal for a LED driver (134), the LED driver (134) providing a constant current to the LED (104; 121; 138).

3. The method of claim 2, wherein modifying the duty cycle of the enable signal comprises:

   providing a clock signal;
   adjusting a duty cycle of the clock signal on the basis of a temperature signal indicative of the junction temperature, thereby generating the duty cycle adjusted enable signal.

4. The method of claim 3, wherein the clock signal has a saw tooth waveform with a substantially constant frequency, the method further comprising:

   comparing the clock signal and the temperature signal; and
   generating a transition of the enable signal when the clock signal exceeds the temperature signal and when the clock signal falls short of the temperature signal.

5. The method of one of claims 1 to 4, further comprising:

   receiving a control signal indicative of a desired intensity of the light emitted by the LED (104; 121; 138); and
   on the basis of the determined junction temperature, determining whether the control signal exceeds a predefined threshold,

   wherein the average current is modified in case the control signal exceeds the predefined threshold.

6. The method of one of claims 1 to 5, wherein determining the junction temperature of the LED (104; 121; 138) comprises:

   detecting an ambient temperature at the LED (104; 121; 138); and
   determining the junction temperature on the basis of the detected ambient temperature, a thermal path from the LED junction to ambient and the power dissipated by the LED (104; 121; 138).

7. A controller (130) for a LED (104; 121; 138), comprising:

   an input (154) for receiving an input signal indicative of a junction temperature of the LED (104; 121; 138);
   an enable signal generator for generating an enable signal having a duty cycle;
   a processor (160) coupled to the input (154) and to the enable signal generator, the processor (160) configured to modify the duty cycle of the enable signal on the basis of the input signal; and
   an output (158) coupled to the enable signal generator for outputting the enable signal.

8. The controller (130) of claim 7, further comprising a control input (156) for receiving a control signal indicative of a desired intensity of the light emitted by the LED (104; 121; 138),
   wherein the processor (160) is configured to determine whether the control signal exceeds a predefined threshold, on the basis of the determined junction temperature, and to modify the average current in case the control signal exceeds the predefined threshold.

9. The controller (130) of claim 7 or 8, comprising:

   an oscillator (162); and
   a comparator (164) having a first input coupled to the oscillator (162), a second input coupled to the input (154), and an output coupled to the output (158).

10. The controller (130) of claim 9, wherein the oscillator (162) is configured to provide a saw tooth waveform having a substantially constant frequency.

**11.** A LED (132), comprising:

a LED chip (138);
a temperature sensor (142, 144) arranged to measure the temperature at the LED chip (138); and
a controller (130) of one of claims 7 to 10.

**12.** A display device (100), comprising:

a display unit (108);
a LED back lightning system having one or more LEDs (104; 121; 138); and
a controller (130) of one of claims 7 to 10.

**13.** The display device (100) of claim 12, wherein the display unit (108) is a liquid crystal display (LCD).

FIG 1

FIG 2A

FIG 2B

EP 2 073 607 A1

FIG 3A

FIG 3B

116a

118a        120        118a

116a

116    112    120

114

108

EP 2 073 607 A1

# FIG 4A

EP 2 073 607 A1

# FIG 4B

EP 2 073 607 A1

## FIG 5A

## FIG 5B

## FIG 6A

## FIG 6B

# FIG 7

EP 2 073 607 A1

**European Patent Office**

**EUROPEAN SEARCH REPORT**

Application Number

EP 07 02 4653

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2007/019663 A (TIR SYSTEMS LTD [CA]; JUNGWIRTH PAUL [CA]; ROBINSON SHANE P [CA]; SPEI) 22 February 2007 (2007-02-22) * pages 7-19; figure 1 * ----- | 1-13 | INV. H05B33/08 |
| X | US 2004/207532 A1 (SMITHSON BRADLEY D [CA]) 21 October 2004 (2004-10-21) * paragraphs [0015] - [0020]; figure 3 * ----- | 1-13 | |
| X | EP 1 313 353 A (NOKIA CORP [FI]) 21 May 2003 (2003-05-21) * paragraphs [0028] - [0033] * ----- | 1-13 | |
| X | US 5 783 909 A (HOCHSTEIN PETER A [US]) 21 July 1998 (1998-07-21) * columns 3,4 * ----- | 1-13 | |
| X | WO 2006/111689 A (RADIANT RES LTD [GB]; ARCHENHOLD GEOFFREY HOWARD GIL [GB]; ANDERSON KE) 26 October 2006 (2006-10-26) * pages 18-20; figure 4 * ----- | 1-13 | TECHNICAL FIELDS SEARCHED (IPC) H05B |

The present search report has been drawn up for all claims

| Place of search | Date of completion of the search | Examiner |
|---|---|---|
| Munich | 9 June 2008 | Morrish, Ian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 07 02 4653

This annex lists the patent family members relating to the patent documents cited in  the above-mentioned European search report.
The members are as contained in the European Patent Office EDP file on
The European Patent Office is in no way liable for these particulars which are merely given for the purpose of information.

09-06-2008

| Patent document cited in search report | | Publication date | Patent family member(s) | | Publication date |
|---|---|---|---|---|---|
| WO 2007019663 | A | 22-02-2007 | CA<br>EP | 2619613 A1<br>1922905 A1 | 22-02-2007<br>21-05-2008 |
| US 2004207532 | A1 | 21-10-2004 | NONE | | |
| EP 1313353 | A | 21-05-2003 | US | 2003123521 A1 | 03-07-2003 |
| US 5783909 | A | 21-07-1998 | WO | 9956303 A1 | 04-11-1999 |
| WO 2006111689 | A | 26-10-2006 | EP | 1878317 A1 | 16-01-2008 |

EPO FORM P0459

For more details about this annex : see Official Journal of the European Patent Office, No. 12/82